Europäisches Patentamt

**European Patent Office**

**Office européen des brevets**

(19)

(11) Publication number: **0 120 119**
A2

(12)

# EUROPEAN PATENT APPLICATION

(21) Application number: **83110682.8**

(22) Date of filing: **26.10.83**

(51) Int. Cl.³: **C 25 D 11/20**
**C 25 D 11/06, H 05 K 3/00**

(30) Priority: **27.12.82 US 452993**

(43) Date of publication of application:
**03.10.84 Bulletin 84/40**

(84) Designated Contracting States:
**DE FR GB**

(71) Applicant: **International Business Machines Corporation**
**Old Orchard Road**
**Armonk, N.Y. 10504(US)**

(72) Inventor: **Mahmoud, Issa Said**
**10500 Settlers Trail**
**Austin Texas 78750(US)**

(74) Representative: **Colas, Alain**
**Compagnie IBM France Département de Propriété**
**Industrielle**
**F-06610 La Gaude(FR)**

(54) Sealing thick anodic coatings on aluminium substrates.

(57) Aluminium work pieces are hard anodized to form thick anodic coatings. The work pieces are then treated with silica which treatment results in sealed substrates suitable for the application of printed circuitry patterns.

EP 0 120 119 A2

SEALING THICK ANODIC COATINGS ON ALUMINIUM SUBSTRATES

Description

Technical Field

This invention relates to substrates for printed circuit boards. More particularly, it relates to producing thick anodic films on aluminium in an improved manner, such that the film is suitable for subsequent circuit pattern generation thereon.

Background Art

Aluminium and aluminium alloys have long been anodically treated in a suitable electrolyte to produce an oxide layer $\gamma-Al_2O_3$, the thickness, appearance and morphology of which depend on processing factors such as time, temperature and electrolyte type. Anodizing has been used extensively in commercial applications to provide decorative and protective finishes for aluminium. Anodizing has also been used to increase surface hardness and wear resistance of aluminium. Anodized aluminium has been used to provide insulating layers in electrolytic capacitors.

More recently, anodized aluminium has been used as the base material for electronic circuitry applications. A one-sided microcircuitized substrate comprising a combination of anodized aluminium at a thickness of 25μm and an equally thick epoxy layer. Some substrates having thicker anodized layers are also known.

Thick anodized aluminium layers, between 100 to 150μm have been demonstrated to be porous and to have microcraks or to develop same on heating. As a result of the difference in the thermal coefficients of expansion between the anodic coating and the base material, the presence of these flaws decreases greatly the dielectric strength of anodized aluminium coatings. Such flaws may be filled with air and other gases which, upon application of an electric field, ionize and conduct electric currents.

Many techniques have been developed for sealing anodic oxide coatings according to Wernick et al in "Surface Treatment of Aluminium".

## Disclosure of Invention

In the present invention, the aluminium substrate is subjected to surface treatment for cleaning and etching. After a rinse in tap water, the substrate is anodized to obtain a 100 to 150μm coating thickness. Following another tap water rinse, a new sealing step is performed by reacting the anodic coating with colloidal silica. The substrates are then ready to receive circuit patterns.

## Best Mode for Carrying Out the Invention

The aluminium surface is simultaneously cleaned and etched in the following solution :

$$
\begin{array}{ll}
\text{phosphoric acid,....} & \text{80 \% by volume ;} \\
\text{nitric acid,........} & \text{5 \% by volume ;} \\
\text{oxalic acid,........} & \text{3 grams by weight ; and} \\
\text{water,..............} & \text{15 \% by volume.}
\end{array}
$$

The solution is heated to 82° C and the aluminium work piece is immersed for two to three minutes. A rinse in tap water follows. To anodize the aluminium work piece, it is treated in a conventional hard anodizing bath preferably in a dilute solution consisting of :

$$
\begin{array}{ll}
\text{sulfuric acid....} & 25\pm5\text{m}\ell/\ell \text{ ;} \\
\text{oxalic acid......} & 8\pm2\text{g}/\ell \text{ ;} \\
\text{urea............} & (1\text{g}/\ell) \text{ and}
\end{array}
$$

0120119

a low foaming surfactant of the phosphate ester emulsifier type such as Tryfac$^{TM}$ 5569 or Tryfac$^{TM}$ 610-A from Emery Industries.

The aluminium work piece is treated for 45-60 minutes at a temperature between 0 and 5° C and at current density of 1-2 amp/dm$^2$. This current density is maintained by varying the applied voltage. A coating thickness of 75µm to 125µm results. The work piece is again rinsed in tap water. The sealing step requires reacting the anodized coating with colloidal silica, known as LUDOX$^{TM}$, of E.I. DuPont De Nemours and Company, is a form of such colloidal silica. Ammoniated LUDOX of the negatively charged AS-type having a particle size of approximatively 22nm is preferred. The anodized aluminium work piece is electrolytically treated in an acidified solution of LUDOX. The pH of the solution is maintained between 3 and 4. A treatment time of 20-30 minutes at room temperature is preferred. The LUDOX solution consists of 150 to 500 ml of LUDOX as, 1000 ml of distilled water, and acidified to a pH of 3 to 4 with concentrated sulfuric acid using vigorous agitation.

The above described process produces substrates having an anodic coating of increased dielectric strength as compared to unsealed coatings.

The sealing step is accomplished by using the anodized aluminium work piece as anodes in an electrolytic cell. A current density of 100-200 mamp/dm$^2$ and a duration of 20 minutes minimum at room temperature is preferred.

This sealing step utilizes a method in which cracks in the anodic coating are filled with polymerized silica having a thermal coefficient of expansion substantially comparable of that of the coating.

0120119

## Claims

1.  A method of making substrates for printed circuit board manufacture characterized in that it includes the steps of :

    anodizing an aluminium work piece ; and

    treating the anodized work piece with silica.

2.  The method of claim 1 wherein the anodizing step takes place in a dilute solution of sulphuric acid and a low sudsing surfactant.

3.  The method of claim 2 wherein the anodizing step takes place during the 45-60 minutes at 0°C - 5°C temperature.

4.  The method of claim 3 where current density is maintained between 1 and 2 amps/dm$^2$.

5.  The method of claim 4 wherein anodizing occurs at a voltage level of a minimum 20 volts.

6.  The method according to any one of the preceding claims wherein the treating step comprises reacting the anodized work piece with colloical silica for 20-30 minutes.

7.  The method of claim 6 where the silica used is the negatively charged AS-type having a particle size of approximatively 22μm.

8.  The method according to any one of claims 1 to 5 wherein the treating step comprises electrolytically treating the anodized work piece in an acidified solution of silica.

9.  The method of claim 8 wherein the pH of the acidified colloidal silica solution is between 3 and 4.

10. A substrate for use in printed circuit manufacture comprising :

a hard, anodized aluminium work piece which has been sealed in an acidified solution of colloidal silica.